(19) Europäisches Patentamt
European Patent Office
Office européen des brevets

(11) **EP 2 751 583 B1**

(12) **FASCICULE DE BREVET EUROPEEN**

(45) Date de publication et mention
de la délivrance du brevet:
**13.04.2016 Bulletin 2016/15**

(21) Numéro de dépôt: **11763961.7**

(22) Date de dépôt: **29.08.2011**

(51) Int Cl.:
***G01R 29/02*** *(2006.01)*

(86) Numéro de dépôt international:
**PCT/FR2011/051978**

(87) Numéro de publication internationale:
**WO 2013/030466 (07.03.2013 Gazette 2013/10)**

(54) **DISPOSITIF DE MESURE D'UNE DURÉE D'UN NIVEAU D'UN SIGNAL ÉLECTRIQUE**

VORRICHTUNG ZUR MESSUNG DER DAUER DES PEGELS EINES ELEKTRISCHEN SIGNALS

DEVICE FOR MEASURING A DURATION OF A LEVEL OF AN ELECTRICAL SIGNAL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(43) Date de publication de la demande:
**09.07.2014 Bulletin 2014/28**

(73) Titulaire: **Asahi Kasei Microdevices Corporation
Tokyo 101-8101 (JP)**

(72) Inventeurs:
• **CANARD, David
92210 Saint Cloud (FR)**
• **LECUYER, Matthieu
F-92210 Saint Cloud (FR)**

(74) Mandataire: **Cabinet Plasseraud
66, rue de la Chaussée d'Antin
75440 Paris Cedex 09 (FR)**

(56) Documents cités:
**US-A1- 2011 090 015**

**Description**

La présente invention concerne un dispositif de mesure d'une durée d'un niveau d'un signal électrique.

La mesure d'une durée d'un signal électrique est une opération importante dans de multiples domaines tels que la métrologie, les télécommunications etc.

Une solution classique consiste à compter le nombre d'impulsions générées par un oscillateur pendant la durée du signal électrique à mesurer.

Les techniques de réalisation d'un oscillateur sont multiples et offrent toutes des avantages et des désavantages.

Les oscillateurs en anneau sont très intéressants pour une réalisation sous la forme d'un circuit intégré mais leurs caractéristiques sont très sensibles aux variations de leur tension d'alimentation.

Si l'on souhaite utiliser un oscillateur en anneau, il est alors primordial de délivrer une tension d'alimentation qui soit la plus stable possible et dépourvue de bruit.

Ces impératifs limitent les conditions d'utilisations de tels oscillateurs.

Le document US2011/0090015 décrit un circuit intégré à semi-conducteurs et dispositif électronique.

La présente invention a pour but de résoudre les inconvénients de l'art antérieur en proposant un dispositif de mesure d'une durée d'un niveau d'un signal électrique qui soit insensible au bruit sur son alimentation électrique et aux éventuelles variations de la tension d'alimentation.

A cette fin, selon un premier aspect, l'invention propose un dispositif de mesure d'une durée d'un niveau d'un signal électrique caractérisé en ce que le dispositif comporte :

- un premier oscillateur en anneau constitué de portes inverseuses dont l'alimentation électrique est modulée par le signal électrique,
- un second oscillateur en anneau dont l'alimentation électrique n'est pas modulée par le signal électrique,
- des moyens de comptage du nombre total de transitions de porte en porte d'un point d'instabilité du premier oscillateur en anneau, un point d'instabilité étant présent au niveau d'une porte inverseuse lorsque le niveau logique à l'entrée de la porte inverseuse est égal au niveau logique en sortie de la porte inverseuse,
- des moyens de comptage du nombre total de transitions de porte en porte d'un point d'instabilité du second oscillateur en anneau,
- des moyens de détermination de la durée du niveau du signal électrique à partir des valeurs des moyens de comptage.

Ainsi, le comptage des transitions du premier oscillateur modulé et représentant la durée du niveau du signal électrique peut être corrigé par le comptage des transitions du second oscillateur, non modulé.

Les erreurs liées aux fluctuations de la tension d'alimentation, telles celles liées au bruit sur la tension d'alimentation sont ainsi corrigées.

La présente invention permet ainsi de réaliser une mesure d'une durée d'un niveau d'un signal électrique très précise avec un circuit intégré. La présente invention, de par son implémentation sous la forme d'un circuit microélectronique peut ainsi être utilisée dans des systèmes embarqués tels que par exemple des téléphones mobiles.

Selon un mode particulier de l'invention, le signal électrique est un signal électrique périodique et les comptages sont effectués pendant une période du signal électrique périodique.

Ainsi, le nombre de transitions peut être obtenu par la différence de deux comptages successifs espacés d'une période régulière. Il n'est pas nécessaire de synchroniser les comptages avec les fronts du signal à mesurer.

L'implémentation de l'invention est alors simplifiée.

Selon un mode particulier de l'invention, la fréquence du premier oscillateur en anneau est à une première fréquence lorsque le signal électrique est à un premier niveau et à une seconde fréquence lorsque le signal électrique est à un second niveau.

Ainsi, le nombre de transitions entre deux comptages est une fonction linéaire de la durée du niveau du signal électrique.

Selon un mode particulier de l'invention, les première et seconde fréquences sont non nulles.

Ainsi, les oscillateurs ne sont jamais remis à zéro et conservent la mémoire des comptages précédents. Les erreurs de quantification de chaque comptage sont accumulées de période en période et la précision de la mesure s'améliore de cycle en cycle. Ceci permet de mettre en forme le bruit de quantification avec une atténuation de ses composantes basses fréquences.

Selon un mode particulier de l'invention, le dispositif comporte en outre, pour chaque porte des oscillateurs en anneau, un comparateur à verrouillage.

Ainsi, il est possible d'extraire et mémoriser l'état de tous les niveaux logiques de l'oscillateur à un instant donné et de localiser le point d'instabilité.

Selon un mode particulier de l'invention, les moyens de comptage de chaque oscillateur en anneau comportent deux compteurs et le dispositif comporte en outre des moyens de sélection, pour chaque oscillateur en anneau, d'un compteur parmi les deux compteurs en fonction de la position du point d'instabilité dans l'oscillateur en anneau.

Ainsi, il est possible d'utiliser des oscillateurs en anneau dont la période est plus courte que celle du signal à mesurer. Les périodes supplémentaires sont mémorisées par les compteurs de tours. Le nombre total de transitions est obtenu par la combinaison du nombre de tours effectués et de la position du point d'instabilité sur le tour en cours à l'instant d'observation.

Selon un mode particulier de l'invention, les portes inverseuses sont des portes différentielles.

Ainsi, la détection des niveaux logiques dans l'oscillateur est plus fiable.

Le fait que les portes inverseuses soient différentielles permet de s'affranchir des erreurs de mode commun inhérentes aux structures asymétriques. Ces erreurs sont notamment liées au bruit d'alimentation, aux variations des niveaux de référence de comparaison d'étage en étage.

Selon un mode particulier de l'invention, le temps de propagation des portes inverseuses du premier oscillateur en anneau est différent du temps de propagation des portes inverseuses du second oscillateur en anneau.

Ainsi, il est possible de réduire l'encombrement du dispositif selon la présente invention lorsque celui-ci est implémenté sous forme de circuit intégré et l'implémentation de la présente invention est simplifiée.

L'invention concerne aussi une boucle à verrouillage de phase caractérisée en ce qu'elle comporte un dispositif de mesure d'une durée d'un niveau d'un signal électrique selon la présente invention.

Ainsi, la présente invention permet de mesurer la durée du niveau du signal qui dans le cas d'une boucle à verrouillage de phase porte l'information de différence de phase du système. La présente invention permet de réaliser la conversion analogique numérique de manière fiable et précise.

L'insensibilisation au bruit de l'alimentation permet la réalisation de boucles à verrouillage de haute performance en bruit de phase.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

la Fig. 1 représente un exemple de boucle à verrouillage de phase numérique dans laquelle la présente invention est implémentée ;
la Fig. 2 représente un module de mesure de la durée d'une impulsion utilisant deux oscillateurs en anneau selon la présente invention ;
la Fig. 3 représente un exemple d'oscillateur en anneau et de son décodeur associé ;
la Fig. 4 représente un exemple de variations des décodeurs associés aux deux oscillateurs en anneau selon la présente invention.

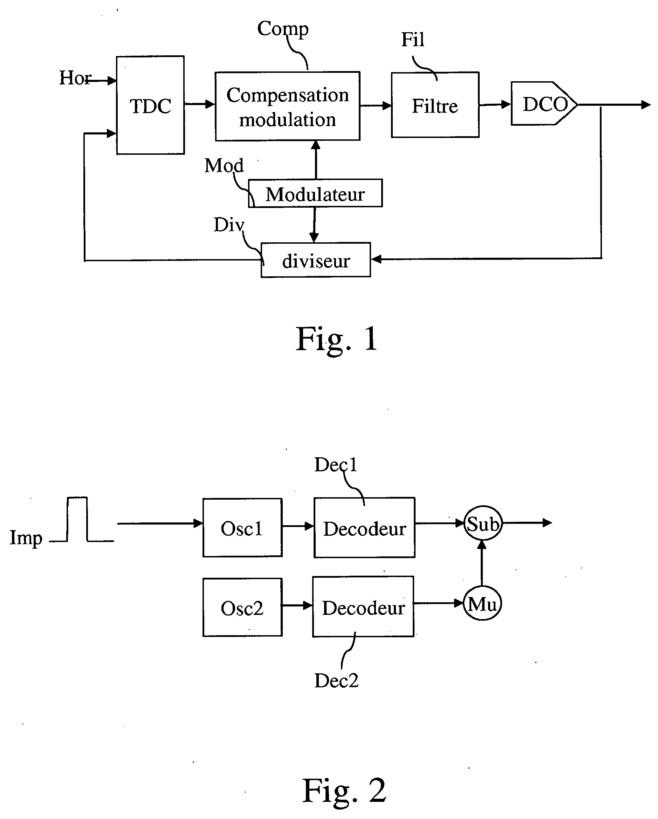

La **Fig. 1** représente un exemple de boucle à verrouillage de phase numérique dans laquelle la présente invention est implémentée.

Une boucle à verrouillage de phase permet d'asservir la phase instantanée d'un signal de sortie sur la phase instantanée d'un signal de fréquence fixe. Une boucle à verrouillage de phase permet de synthétiser une horloge de fréquence programmable à partir du signal de fréquence fixe Hor.

Une boucle à verrouillage numérique est constituée d'un convertisseur temps numérique TDC, d'un filtre de boucle numérique Fil, d'un oscillateur contrôlé numériquement DCO et d'un diviseur Div.

Eventuellement, la boucle à verrouillage numérique comporte aussi un module de compensation de modulation Comp et un modulateur Mod.

L'horloge de référence Hor est comparée par le convertisseur temps numérique TDC au signal de sortie de l'oscillateur contrôlé numériquement DCO divisé par le diviseur Div.

A chaque cycle de l'horloge de référence, la différence de phase entre l'horloge de référence Hor et le signal de sortie de l'oscillateur contrôlé numériquement DCO divisé est convertie en une impulsion correspondante notée Imp.

Le convertisseur temps numérique TDC comprend, selon la présente invention, un module de mesure de la durée d'une impulsion utilisant deux oscillateurs en anneau. Le module de mesure de la durée d'une impulsion de niveau haut utilisant deux oscillateurs en anneau mesure la durée de cette impulsion. Le module de mesure de la durée d'une impulsion sera décrit plus en détail en référence à la Fig. 2.

La durée du niveau haut du signal Imp est fournie à un module de compensation de modulation Comp.

Le modulateur Mod est par exemple un modulateur SIGMA DELTA et a pour fonction de moduler la valeur du rapport de division de cycle en cycle pour obtenir un ratio non entier entre la fréquence de l'oscillateur contrôlé numériquement DCO et celle du signal de référence.

Le module de compensation de modulation Comp est par exemple un module de compensation de modulation SIGMA DELTA.

Le module de compensation de modulation Comp permet de compenser de cycle en cycle les erreurs de phase générées par les commutations qui dégradent la pureté spectrale du signal. Ces erreurs sont aisément traitées par le module de compensation de modulation Comp qui effectue un traitement numérique sur le signal.

Le signal délivré par le module de compensation de modulation Comp est ensuite filtré par un filtre numérique Fil.

Le filtre Fil permet de stabiliser la boucle à verrouillage de phase et d'ajuster les paramètres dynamiques de la boucle à verrouillage de phase en fonction de l'application dans laquelle la boucle à verrouillage de phase est employée. Les paramètres dynamiques de la boucle à verrouillage de phase sont par exemple la bande passante et le coefficient d'amortissement. Ces paramètres sont déterminants pour la performance en bruit de phase de la boucle à verrouillage de phase.

Le filtre Fil permet également de supprimer une partie de l'énergie de la modulation fractionnelle.

La sortie du filtre Fil commande l'oscillateur contrôlé numériquement DCO qui délivre un signal asservi en phase.

Le signal asservi en phase est divisé par le diviseur Div relié au convertisseur temps numérique TDC.

La **Fig. 2** représente un module de mesure de la durée d'une impulsion utilisant deux oscillateurs en anneau selon la présente invention.

Un oscillateur en anneau est composé d'un nombre impair de portes inverseuses, appelées aussi portes Non, dont les sorties oscillent entre deux niveaux de tension. Les portes sont reliées en chaîne et la sortie de la dernière porte de la chaîne est reliée à l'entrée de la première porte inverseuse de la chaîne.

La fréquence délivrée par un oscillateur en anneau dépend du nombre de portes inverseuses et du temps de propagation des portes.

Selon l'invention, le module de mesure de la durée d'une impulsion comporte un premier oscillateur en anneau Osc1 qui délivre une première mesure de la durée de l'impulsion Imp.

Selon l'invention, le signal Imp module la tension d'alimentation nominale de l'oscillateur en anneau Osc1.

Par exemple et de manière non limitative, la tension nominale de l'alimentation est de 1,2 Volts. Lorsque le signal Imp est au niveau haut, la tension d'alimentation de l'oscillateur en anneau Osc1 est égale à 95% de la tension nominale, soit de l'ordre de 1,15 Volts, et lorsque le signal Imp est au niveau bas, la tension d'alimentation de l'oscillateur en anneau Osc1 est non nulle, égale par exemple à 70% de la tension nominale, soit de l'ordre de 0,85 Volts.

Un oscillateur en anneau est très sensible aux variations de sa tension d'alimentation. La fréquence de sortie de l'oscillateur en anneau Osc1 est ainsi modifiée selon que le signal Imp est au niveau haut ou au niveau bas.

Un oscillateur en anneau comporte un point d'instabilité. Le point d'instabilité d'un oscillateur en anneau se situe au niveau d'une porte inverseuse dont le niveau logique d'entrée est le même que le niveau logique de sortie de la porte inverseuse. Le point d'instabilité se déplace de porte en porte dans l'oscillateur en anneau.

Le nombre de tours effectués par le point d'instabilité dans l'oscillateur en anneau Osc1 pendant les niveaux haut et bas du signal Imp est compté par les compteurs CountA et CountB. La position du point d'instabilité sur le tour en cours est mémorisée par les comparateurs à verrouillage. Le décodeur Dec1 combine ces deux informations pour fournir le nombre total de transitions depuis le précédent instant d'échantillonnage de manière à augmenter la précision de la mesure de la durée de l'impulsion.

Selon l'invention, le module de mesure de la durée d'une impulsion comporte un second oscillateur en anneau Osc2 qui oscille indépendamment de l'impulsion Imp.

La tension d'alimentation du second oscillateur en anneau Osc2 n'est pas modulée par le signal Imp et correspond à la tension nominale de l'alimentation qui est par exemple de l'ordre de 1,2 Volts.

Le nombre de tours effectués par le point d'instabilité dans l'oscillateur en anneau Osc2 pendant les niveaux haut et bas du signal Imp est compté par des compteurs similaires aux CountA et CountB. La position du point d'instabilité sur le tour en cours est mémorisée par les comparateurs à verrouillage. Le décodeur Dec2 combine ces deux informations pour fournir le nombre total de transitions depuis le précédent instant d'échantillonnage.

Lorsque la tension d'alimentation nominale varie, variation par exemple liée au bruit de commutation des composants électroniques ou autres, celle-ci modifie la fréquence de l'oscillateur en anneau Osc1 et provoque une erreur sur la mesure de l'impulsion Imp.

Lorsque la tension d'alimentation nominale varie, les temps de propagation des portes inverseuses des deux oscillateurs en anneau Osc1 et Osc2 varient proportionnellement au carré de la variation de la tension d'alimentation.

En utilisant le second oscillateur en anneau selon la présente invention, il est alors possible de compenser l'erreur sur la mesure du niveau haut du signal Imp liée à d'éventuelles variations de la tension d'alimentation nominale.

Il est à remarquer ici que le nombre de portes inverseuses comprises dans l'oscillateur en anneau Osc2 est égal ou différent du nombre de portes inverseuses comprises dans l'oscillateur en anneau Osc1.

Pour des raisons d'encombrement du module de mesure de la durée d'une impulsion, le nombre de portes inverseuses comprises dans l'oscillateur en anneau Osc2 est inférieur au nombre de portes inverseuses comprises dans l'oscillateur en anneau Osc1.

Lorsque le temps de propagation des portes inverseuses comprises dans l'oscillateur en anneau Osc2 est différent du temps de propagation des portes inverseuses comprises dans l'oscillateur en anneau Osc1, le module de mesure de la durée d'une impulsion peut comporter un multiplieur Mu qui multiplie l'information délivrée par le décodeur Dec2 par un coefficient multiplicatif déterminé en fonction du rapport entre le temps de propagation des portes inverseuses comprises dans l'oscillateur en anneau Osc2 et le temps de propagation des portes inverseuses comprises dans l'oscillateur en anneau Osc1.

Lorsque les structures électriques des portes inverseuses des oscillateurs Osc1 et Osc2 sont différentes, le temps de propagation d'une porte inverseuse étant fonction de sa structure, les temps de propagation des portes inverseuses des oscillateurs Osc1 et Osc2 sont différents.

Les informations délivrées par les décodeurs Dec1 et Dec2 sont ensuite soustraites de manière à compenser les éventuelles variations de la tension d'alimentation nominale.

La soustraction établit la consigne du système. Le filtre de boucle Fil est fondamentalement un intégrateur et l'état stable de la boucle à verrouillage de phase n'est atteint que lorsque son entrée, le résultat de la soustraction, est nulle en moyenne.

La durée d'un niveau d'un signal électrique mesuré est telle que le nombre de transitions sur l'oscillateur Osc1 est égal au nombre de transitions sur l'oscillateur Osc2 multipliée par le coefficient du multiplieur Mu .

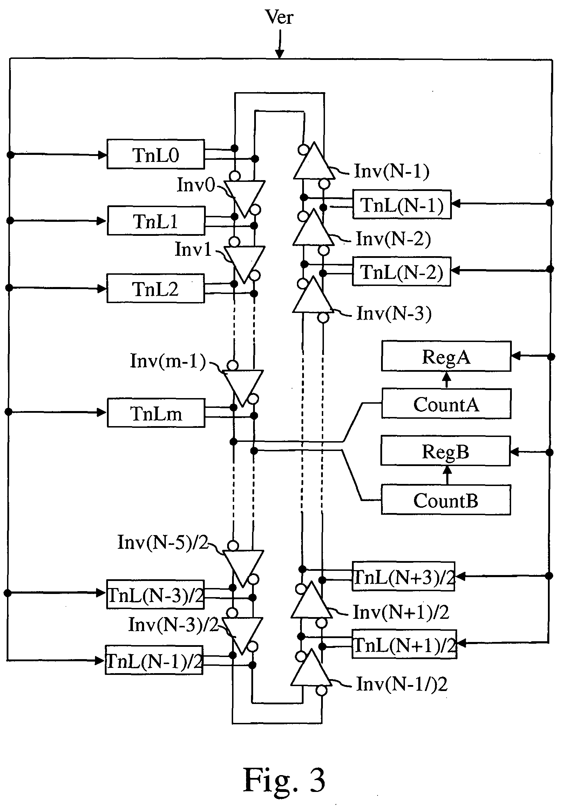

La **Fig. 3** représente un exemple d'oscillateur en anneau et de son décodeur associé.

La Fig. 3 représente l'oscillateur en anneau Osc1 ainsi que le décodeur Dec1.

Le dispositif de modulation de la tension d'alimentation de l'oscillateur en anneau Osc1 n'est pas représenté dans la Fig. 3 par souci de simplification.

Il est à remarquer ici que l'oscillateur en anneau Osc2 et le décodeur Dec2 ont la même structure que celle décrite dans la Fig. 3.

L'oscillateur en anneau Osc1 est composé de N portes inverseuses Inv0 à Inv(N-1).

Seules les portes inverseuses Inv0, Inv1, Inv(m-1), Inv(N-5)/2, Inv(N-3)/2, Inv(N-1)/2, Inv(N+1)/2, Inv(N-3), Inv(N-2) et Inv(N-1) sont représentées par souci de simplification.

Les portes inverseuses Inv0 à Inv(N-1) sont préférentiellement des portes inverseuses différentielles qui permettent d'obtenir des mesures plus précises.

En entrée de chaque porte inverseuse Inv0 à Inv(N-1) sont placés des comparateurs à verrouillage TnL0 à TnL(N-1) (en anglais Track and Latch Comparator).

Seuls les comparateurs à verrouillage TnL0, TnL1, TnL2, TnL(m), TnL(N-3)/2, TnL(N-1)/2, TnL(N+1)/2, TnL(N+3)/2, TnL(N-2) et TnL(N-1) sont représentés par souci de simplification.

Les comparateurs à verrouillage TnL0 à TnL(N-1) mémorisent les états logiques en entrée de chaque porte inverseuse Inv0 à Inv(N-1) sur le front montant du signal de verrouillage Ver. La sortie de ces comparateurs est décodée pour déterminer la position de l'instabilité dans la boucle par un décodeur non représenté dans la Fig. 3.

Un premier compteur countA est placé sur une première sortie d'une porte inverseuse, par exemple la porte inverseuse Inv(m-1). Par exemple, le premier compteur countA est placé sur la sortie positive de la porte inverseuse différentielle Inv(m-1).

Un second compteur countB est placé sur la seconde sortie de la même porte inverseuse Inv(m-1). Par exemple, le premier compteur countA est placé sur la sortie négative de la porte inverseuse différentielle Inv(m-1).

Les compteurs CountA et CountB comptent les tours complets effectués par le point d'instabilité.

Un registre RegA déclenché par le signal de verrouillage Ver est relié au compteur CountA.

Le signal de verrouillage Ver effectue un échantillonnage une fois par cycle de l'horloge de référence de la PLL.

Un registre RegB déclenché par le signal de verrouillage Ver est relié au compteur CountB.

Selon l'invention, on sélectionne la valeur du compteur CountA ou CountB selon la position du point d'instabilité dans l'oscillateur en anneau Osc1.

En effet, les registres en sortie des compteurs en mémorisent le contenu sur le front montant du signal de verrouillage. Dans certains cas, il peut arriver qu'un compteur soit en cours de changement d'état au moment du front montant d'échantillonnage, produisant ainsi des données corrompues. Si les données d'un registre sont ainsi inutilisables, celles du deuxième compteur sont forcément valides puisque il se trouve à l'opposé de l'anneau du point de vue de l'instabilité car les signaux en entrée ou en sortie des portes inverseuses différentielles sont en opposition de phase alors que les deux compteurs CountA et CountB opèrent sur front montant.

Le décodage de la position de l'instabilité permet ainsi de déterminer lequel des Compteurs CountA et CountB contient des données assurément valides.

Le signal de verrouillage Ver est un signal périodique et échantillonne périodiquement l'état des entrées des portes inverseuses Inv0 à Inv(N-1). La valeur des compteurs CountA ou CountB au ième échantillon est notée C[i] et la position de l'instabilité dans l'anneau est notée p[i].

Pour chacun des oscillateurs en anneau Osc1, Osc2, le nombre total de transitions d'étage en étage du point d'instabilité A[i] à l'échantillon i est donné par :

$$A[i]=N* C[i]+ p[i]$$

Entre chaque échantillonnage, le nombre total de transitions de porte en porte du point d'instabilité est égal à :

$$\Delta\Lambda[i] = \Lambda[i] - \Lambda[i-1].$$

Lorsque $\Delta\Lambda[i]$ a une valeur négative, celle-ci correspond à un dépassement de la valeur maximale que peuvent prendre les compteurs CountA et/ou CountB. Une correction des valeurs des compteurs CountA et/ou CountB est alors effectuée.

La durée de l'état haut $\Delta t$ du signal Imp est mesurée à l'aide de l'oscillateur en anneau Oscl. La fréquence délivrée par l'oscillateur Osc1 est égale à $F_{max}$ lorsque le signal Imp est au niveau haut et est égale à $F_{min}$ lorsque le signal Imp est au niveau bas.

Entre deux échantillonnages successifs, soit un intervalle de temps de durée $T_e$ on obtient le nombre de transitions dans l'oscillateur en anneau Osc1:

$$\Delta\Lambda_{osc1}[i] = \Delta t * N * (F_{max} - F_{min}) + Te * N * F_{min}.$$

Entre deux échantillonnages successifs, soit un intervalle de temps de durée $T_e$ on obtient le nombre de transitions dans l'oscillateur en anneau Osc2 :

$\Delta\Lambda_{osc2}[i] = Te * M * F_{osc2}$ où M est le nombre de portes inverseuses de l'oscillateur Osc2 et $F_{osc2}$ est la fréquence de l'oscillateur Osc2.

En effectuant la différence $\Delta\Phi[i]$ entre le nombre de transitions dans l'oscillateur en anneau Osc1 et l'oscillateur Osc2, on obtient :

$$\Delta\Phi[i] = \Delta t * N * (F_{max} - F_{min}) + Te * N * F_{min} - Te * M * F_{osc2}$$

Si l'on calcule la durée $\Delta t_0$ pour laquelle $\Delta\Phi[i]$ est nulle, on obtient :

$$\Delta t_0 = Te * (N * F_{min} - M * F_{osc2}) / (N * (F_{max} - F_{min})).$$

Cette valeur $\Delta t_0$ est la durée de l'impulsion qui produit une valeur nulle à l'entrée du filtre Fil et correspond au point de repos du système, c'est-à-dire un écart de phase constant à l'entrée du convertisseur temps numérique TDC.

Les fréquences Fmax, Fmin et $F_{osc2}$ des oscillateurs étant perturbées dans les mêmes proportions par les variations de l'alimentation, cette grandeur est indépendante desdites variations.

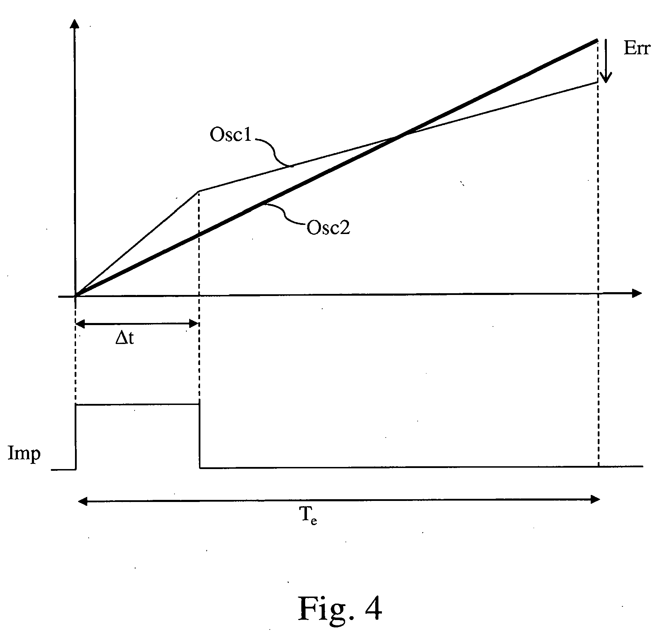

La **Fig. 4** représente un exemple de variations des décodeurs associés aux deux oscillateurs en anneau selon la présente invention.

Sur l'axe des abscisses est représenté le temps.

Dans la Fig. 4, le signal Imp est représenté ainsi que les variations des compteurs des oscillateurs Osc1 et Osc2 entre deux échantillons.

Pendant la durée de l'état haut $\Delta t$ du signal Imp, la fréquence délivrée par l'oscillateur Osc1 est égale à $F_{max}$.

Entre deux échantillonnages successifs, soit durant la durée $T_e$, on obtient le nombre de transitions dans l'oscillateur en anneau Osc1:

$$\Delta\Lambda_{osc1}[i] = \Delta t * N * (F_{max} - F_{min}) + Te * N * F_{min}.$$

Entre deux échantillonnages successifs, soit durant la durée $T_e$, on obtient le nombre de transitions dans l'oscillateur en anneau Osc2 :

$$\Delta\Lambda_{osc2}[i] = Te * M * F_{osc2}.$$

En effectuant la différence $\Delta\Phi[i]$ notée Err dans la Fig. 4 entre le nombre de transitions dans l'oscillateur en anneau Osc1 et l'oscillateur Osc2, on obtient :

$$\Delta\Phi[i] = \Delta t * N * (F_{max} - F_{min}) + Te * N * F_{min} - Te * M * F_{osc2}.$$

Bien entendu, la présente invention n'est nullement limitée aux modes de réalisation décrits ici, mais englobe, bien au contraire, toute variante à la portée de l'homme du métier et particulièrement la combinaison de différents modes de réalisation de la présente invention.

**Revendications**

1. Dispositif de mesure d'une durée d'un niveau d'un signal électrique comportant :

   - un premier oscillateur en anneau constitué de portes inverseuses dont l'alimentation électrique est modulée par le signal électrique,
   - un second oscillateur en anneau dont l'alimentation électrique n'est pas modulée par le signal électrique, **caractérisé en ce qu'**il comporte :
   - des moyens de comptage du nombre total de transitions de porte en porte d'un point d'instabilité du premier oscillateur en anneau, un point d'instabilité étant présent au niveau d'une porte inverseuse lorsque le niveau logique à l'entrée de la porte inverseuse est égal au niveau logique en sortie de la porte inverseuse,
   - des moyens de comptage du nombre total de transitions de porte en porte d'un point d'instabilité du second oscillateur en anneau,
   - des moyens de détermination de la durée du niveau du signal électrique à partir des valeurs des moyens de comptage.

2. Dispositif selon la revendication 1, **caractérisé en ce que** le signal électrique est un signal électrique périodique et **en ce que** les comptages sont effectués pendant une période du signal électrique périodique.

3. Dispositif selon la revendication 1 ou 2, **caractérisé en ce que** la fréquence du premier oscillateur en anneau est à une première fréquence lorsque le signal électrique est à un premier niveau et à une seconde fréquence lorsque le signal électrique est à un second niveau.

4. Dispositif selon la revendication 3, **caractérisé en ce que** les première et seconde fréquences sont non nulles.

5. Dispositif selon l'une quelconque des revendications 1 à 4, **caractérisé en ce que** le dispositif comporte en outre, pour chaque porte des oscillateurs en anneau, un comparateur à verrouillage.

6. Dispositif selon l'une quelconque des revendications 1 à 5, **caractérisé en ce que** les moyens de comptage de chaque oscillateur en anneau comportent deux compteurs et **en ce que** le dispositif comporte en outre des moyens de sélection, pour chaque oscillateur en anneau, d'un compteur parmi les deux compteurs en fonction de la position du point d'instabilité dans l'oscillateur en anneau.

7. Dispositif selon l'une quelconque des revendications 1 à 6, **caractérisé en ce que** les portes inverseuses sont des portes différentielles.

8. Dispositif selon l'une quelconque des revendications 1 à 6, **caractérisé en ce que** le temps de propagation des portes inverseuses du premier oscillateur en anneau est différent du temps de propagation des portes inverseuses du second oscillateur en anneau.

9. Boucle à verrouillage de phase **caractérisée en ce qu'**elle comporte un dispositif de mesure d'une durée d'un niveau d'un signal électrique selon l'une quelconque des revendications 1 à 8.

**Patentansprüche**

1. Messvorrichtung der Dauer eines Pegels eines elektrischen Signales, umfassend:

   - einen ersten Ringoszillator, der aus zwei Nicht-Gattern besteht, deren Stromversorgung durch das elektrische Signal moduliert ist,
- einen zweiten Ringoszillator, dessen Stromversorgung nicht durch das elektrische Signal moduliert ist, **dadurch gekennzeichnet, dass** sie umfasst:
- ein Zählmittel der Gesamtanzahl von Übergängen von Gatter zu Gatter eines Punktes der Instabilität des ersten Ringoszillators, wobei ein Punkt der Instabilität auf dem Pegel eines Nicht-Gatters vorhanden ist wenn der Logikpegel am Eingang des Nicht-Gatters gleich einem Logikpegel am Ausgang des Nicht-Gatters ist,
- ein Zählmittel der Gesamtanzahl von Übergängen von Gatter zu Gatter eines Punkts der Instabilität des zweiten Ringoszillators,
- ein Bestimmungsmittel der Dauer des Pegels des elektrischen Signals ab den Mittelwerten der Zählung.

2. Vorrichtung gemäß Anspruch 1, **dadurch gekennzeichnet, dass** das elektrische Signal ein periodisches, elektrisches Signal ist, und dadurch, dass die Zählungen während einer Periode des periodischen elektrischen Signals vorgenommen werden.

3. Vorrichtung gemäß Anspruch 1 oder 2, **dadurch gekennzeichnet, dass** die Frequenz des ersten Ringoszillators auf einer ersten Frequenz ist, wenn das elektrische Signal auf einem ersten Pegel ist und auf einer zweiten Frequenz, wenn das elektrische Signal auf einem zweiten Pegel ist.

4. Vorrichtung gemäß Anspruch 3, **dadurch gekennzeichnet, dass** die ersten und zweiten Frequenzen nicht Null sind.

5. Vorrichtung gemäß einem der Ansprüche 1 bis 4, **dadurch gekennzeichnet, dass** die Vorrichtung weiterhin für jedes Gatter der Ringoszillatoren einen Verriegelungskomparator umfasst.

6. Vorrichtung gemäß einem der Ansprüche 1 bis 5, **dadurch gekennzeichnet, dass** das Zählmittel jedes Ringoszillators zwei Zähler umfasst, und dadurch, dass die Vorrichtung weiterhin ein Auswahlmittel umfasst, für jeden Ringoszillator, eines Zählers aus den zwei Zählern entsprechend der Position des Punkts der Instabilität im Ringoszillator umfasst.

7. Vorrichtung gemäß einem der Ansprüche 1 bis 6, **dadurch gekennzeichnet, dass** die Nicht-Gatter Differenzialgatter sind.

8. Vorrichtung gemäß einem der Ansprüche 1 bis 6, **dadurch gekennzeichnet, dass** die Ausbreitungszeit der Nicht-Gatter des ersten Ringoszillators sich von der Ausbreitungszeit der Nicht-Gatter des zweiten Ringoszillators unterscheidet.

9. Phasenregelschleife, **dadurch gekennzeichnet, dass** sie eine Messvorrichtung für eine Dauer eines Pegels eines elektrischen Signals gemäß einem der Ansprüche 1 bis 8 umfasst.

**Claims**

1. Device for measuring a duration of a level of an electrical signal, comprising:

   - a first ring oscillator consisting of inverter gates whose power supply is modulated by the electrical signal,
   - a second ring oscillator whose power supply is not modulated by the electrical signal,

   **characterized in that** it comprises:

   - means for counting the total number of transitions from gate to gate of a point of instability of the first ring oscillator, a point of instability being present at an inverter gate when the logic level at the input of the inverter gate is equal to the logic level at the output of the inverter gate,
   - means for counting the total number of transitions from gate to gate of a point of instability of the second ring oscillator,
   - means for determining the duration of the level of the electrical signal based on the values from the counting means.

2. Device according to claim 1, **characterized in that** the electrical signal is a periodic electrical signal and **in that** the countings are performed during a period of the periodic electrical signal.

3. Device according to claim 1 or 2, **characterized in that** the frequency of the first ring oscillator is at a first frequency when the electrical signal is at a first level and at a second frequency when the electrical signal is at a second level.

4. Device according to claim 3, **characterized in that** the first and second frequencies are non-zero.

5. Device according to any one of claims 1 to 4, **characterized in that** the device further comprises, for each gate of the ring oscillators, a latch comparator.

6. Device according to any one of claims 1 to 5, **characterized in that** the counting means of each ring oscillator comprise two counters and **in that** the device further comprises means for selecting, for each ring oscillator, one counter among the two counters based on the position of the point of instability in the ring oscillator.

7. Device according to any one of claims 1 to 6, **characterized in that** the inverter gates are differential gates.

8. Device according to any one of claims 1 to 6, **characterized in that** the propagation time of the inverter gates of the first ring oscillator is different from the propagation time of the inverter gates of the second ring oscillator.

9. Phase-locked loop **characterized in that** it comprises a device for measuring a duration of a level of an electrical signal according to any one of claims 1 to 8.

Comp

Fil

Hor → TDC → Compensation modulation → Filtre → DCO →

Mod

Modulateur

Div

diviseur

## Fig. 1

Dec1

Imp → Osc1 → Decodeur → Sub →

Osc2 → Decodeur → Mu

Dec2

## Fig. 2

Fig. 3

Fig. 4

**EP 2 751 583 B1**

**Documents brevets cités dans la description**

- US 20110090015 A